# FASCICULE DE BREVET EUROPEEN

(11) **EP 0 903 746 B1**
(45) Date de publication et mention de la délivrance du brevet: **17.12.2003**
(21) Numéro de dépôt: 98402186.5
(22) Date de dépôt: 04.09.1998
(51) Int. Cl.: G11C 7/06, G11C 7/00

(54) **Dispositif et procédé de lecture/ré-écriture d'une cellule-mémoire vive dynamique**
Verfahren und Vorrichtung zum Lesen und Überschreiben einer dynamischen Speicherzelle
Device and procedure for reading/rewriting a dynamic memory cell

(30) Priorité: 23.09.1997 FR 9711807
(43) Date de publication de la demande: 24.03.1999
(73) Titulaire: STMicroelectronics S.A., 92120 Montrouge (FR)
(72) Inventeur: El Haji, Noureddine, 38100 Grenoble (FR)
(74) Mandataire: Casalonga, Axel

(56) Documents cités:
- EP-A- 0 306 712
- US-A- 5 241 503

## Description

L'invention concerne la lecture/ré-écriture d'une cellule-mémoire ou point mémoire d'une mémoire vive dynamique (DRAM : Dynamic Random Access Memory), en particulier mais non exclusivement pour une cellule-mémoire ou point mémoire à un, deux ou trois transistors.

Par opposition aux mémoires vives statiques (SRAM) dans laquelle l'information mémorisée le reste indéfiniment du moins tant que cette mémoire reste alimentée, les mémoires dynamiques présentent la particularité de nécessiter un rafraîchissement périodique de l'information stockée en raison notamment des courants de fuite parasites qui déchargent la capacité de stockage de chaque point mémoire.

Parmi les cellules de mémoire vives dynamiques, on peut notamment citer celles comportant deux ou trois transistors et celles comportant un seul transistor dont la lecture de l'information détruit cette dernière.

Classiquement, les mémoires vives dynamiques sont organisées en lignes et en colonnes de cellules-mémoire et comprennent, pour chaque colonne, un dispositif d'amplification de lecture/ré-écriture de chaque cellule-mémoire sélectionnée, ce dispositif comprenant des moyens de précharge permettant de précharger la colonne correspondante de la matrice (communément appelée "ligne de bit" ou ("Bit Line" en anglais) par l'homme du métier) à un niveau de tension choisi, et des moyens d'amplification comportant deux inverseurs rebouclés (formant une bascule bistable) formés chacun de deux transistors complémentaires et commandés par deux signaux successifs de lecture et de ré-écriture (communément dénommés respectivement "sense" et "restore" en langue anglaise).

EP-A-0306712 décrit un tel dispositif de lecture/ré-écriture comportant en outre une structure de découplage formée de deux paires de transistors de découplage complémentaires connectés en parallèle, l'une des paires étant connectée entre les deux transistors de l'un des inverseurs et l'autre paire étant connectée entre les deux transistors de l'autre inverseur

Classiquement, ces deux inverseurs sont directement connectés ensemble tête-bêche ce qui peut conduire à un rafraîchissement erroné de la cellule-mémoire si, lors de la lecture, la différence de tension entre la ligne de bit et la ligne de bit de la colonne immédiatement adjacente (qui sert de référence) est inférieure à la tension de décalage ("offset") de l'amplificateur.

L'invention vise à apporter une solution à ce problème tout en diminuant notamment le temps d'accès pour la lecture de l'information mémorisée.

A cet égard, l'invention propose d'insérer, entre les transistors à canal P et les transistors à canal N des deux inverseurs des moyens d'amplification, une structure de découplage qui puisse en outre permettre une diminution du délai d'écriture d'une information dans la cellule-mémoire lors d'un cycle d'écriture tout en n'affaiblissant pas le niveau de la charge stockée dans la capacité de mémorisation, en particulier lors de l'écriture d'un "1" logique.

Telle que revendiquée, l'invention propose donc un dispositif de lecture/ré-écriture d'une cellule-mémoire d'une mémoire vive dynamique organisée en lignes et en colonnes, ce dispositif comprenant, pour chaque colonne, des moyens de précharge et des moyens d'amplification comportant deux inverseurs formés chacun de deux transistors complémentaires et commandés par deux signaux successifs de lecture et de ré-écriture, les moyens d'amplification comprenant une structure de découplage formée de deux paires de transistors de découplage complémentaires connectés en parallèle, l'une des paires étant connectée entre les deux transistors de l'un des inverseurs, et l'autre paire étant connectée entre les deux transistors de l'autre inverseur. Selon une caractéristique générale de l'invention, la structure de découplage est apte à prendre sur commande au moins un premier état dans lequel tous les transistors de découplage sont passants, et un deuxième état dans lequel les deux transistors de découplage ayant un canal de même type de conductivité sont passants (par exemple les transistors de découplage NMOS) tandis que les deux autres transistors de découplage (en l'espèce les transistors PMOS) sont bloqués.

L'invention propose ainsi également un procédé de commande d'un tel dispositif de lecture/ré-écriture dans lequel on place la structure de découplage dans son premier état au cours d'un cycle d'écriture dans la cellule-mémoire et on place la structure de découplage dans son deuxième état au cours d'un cycle de lecture/ré-écriture succédant à une phase de précharge.

En d'autres termes, les deux interrupteurs CMOS de la structure de découplage sont fermés en particulier lors d'un cycle d'écriture dans la mémoire, ce qui n'occasionne pas de perte de niveau de tension due à la tension de seuil des transistors lorsqu'un niveau élevé de tension est destiné à être appliqué à la cellule-mémoire pour l'écriture d'un "1" logique. Le délai d'écriture en est également raccourci.

Par ailleurs, lorsqu'au cours d'un cycle de lecture/ré-écriture, puisque les transistors PMOS (par exemple) des deux interrupteurs CMOS sont bloqués, et que les deux transistors NMOS de ces deux interrupteurs sont passants, on réalise un découplage entre la partie haute de la ligne de bit connectée à toutes les cellules-mémoire et la partie basse de la ligne de bit, de longueur beaucoup plus petite. En conséquence, la capacité de ligne vue par l'amplificateur en lecture est beaucoup plus faible que la capacité totale de la ligne de bit. Il en résulte donc, lorsque le signal de lecture ("sense") est activé, une séparation beaucoup plus rapide entre les niveaux de tension de la ligne de bit et de la ligne de bit de référence. En outre, la lecture proprement dite de l'information mémorisée peut s'effectuer juste après l'activation du signal de lecture ("sense").

La présence de deux interrupteurs CMOS dans la structure de découplage permet en outre un mode de réalisation particulièrement avantageux de l'invention dans lequel les moyens de précharge ne comportent qu'un seul circuit de précharge connecté en parallèle sur les moyens d'amplification. Ce circuit de précharge peut être du côté de la cellule-mémoire ou à l'opposé de la cellule-mémoire par rapport aux moyens d'amplification.

La position du circuit de précharge est sans importance lorsque les grilles de deux transistors de découplage ayant un même type de canal (par exemple les transistors NMOS) sont connectées à une tension de polarisation prédéterminée (en l'espèce VDD) de façon à rendre ces deux transistors de découplage toujours passants. Bien entendu, les grilles des deux autres transistors de découplage (en l'espèce les transistors PMOS) sont commandées par un même signal de commande à deux états logiques de façon à rendre ces deux autres transistors de découplage passants ou bloqués.

Ainsi, selon un mode de mise en oeuvre du procédé selon l'invention, on place alors la structure de découplage dans son premier état au cours de la totalité de la phase de précharge. En d'autres termes, au cours de la totalité de cette phase de précharge, les transistors de découplage PMOS sont également passants.

Ceci étant, il est particulièrement avantageux que le circuit de précharge soit connecté en parallèle sur les moyens d'amplification à l'opposé de la cellule-mémoire par rapport aux moyens d'amplification. Dans ce cas, en combinaison, la structure de découplage est avantageusement apte à prendre un troisième état dans lequel tous les transistors de découplage sont bloqués.

Plus précisément, selon un mode de mise en oeuvre du procédé, dans le cas où l'unique circuit de précharge est connecté en parallèle sur les moyens d'amplification à l'opposé de la cellule-mémoire par rapport aux moyens d'amplification, durant la phase de précharge, on place d'abord la structure de découplage dans son premier état (tous les transistors de découplage passants) puis, juste avant de désactiver les moyens de précharge, on place la structure de découplage dans son troisième état c'est-à-dire que l'on bloque tous les transistors de découplage. Ainsi, on limite la perturbation engendrée par la coupure de la précharge, à la partie basse de la ligne de bit.

D'autres avantages et caractéristiques de l'invention apparaîtront à l'examen de la description détaillée d'un mode de réalisation et de mise en oeuvre, nullement limitatif, et des dessins annexés sur lesquels :
la figure 1 illustre schématiquement la structure d'un dispositif de lecture/ré-écriture selon l'invention et,
la figure 2 illustre schématiquement un mode de fonctionnement du dispositif selon l'invention dans le cas d'une lecture/ré-écriture d'un "1" logique.

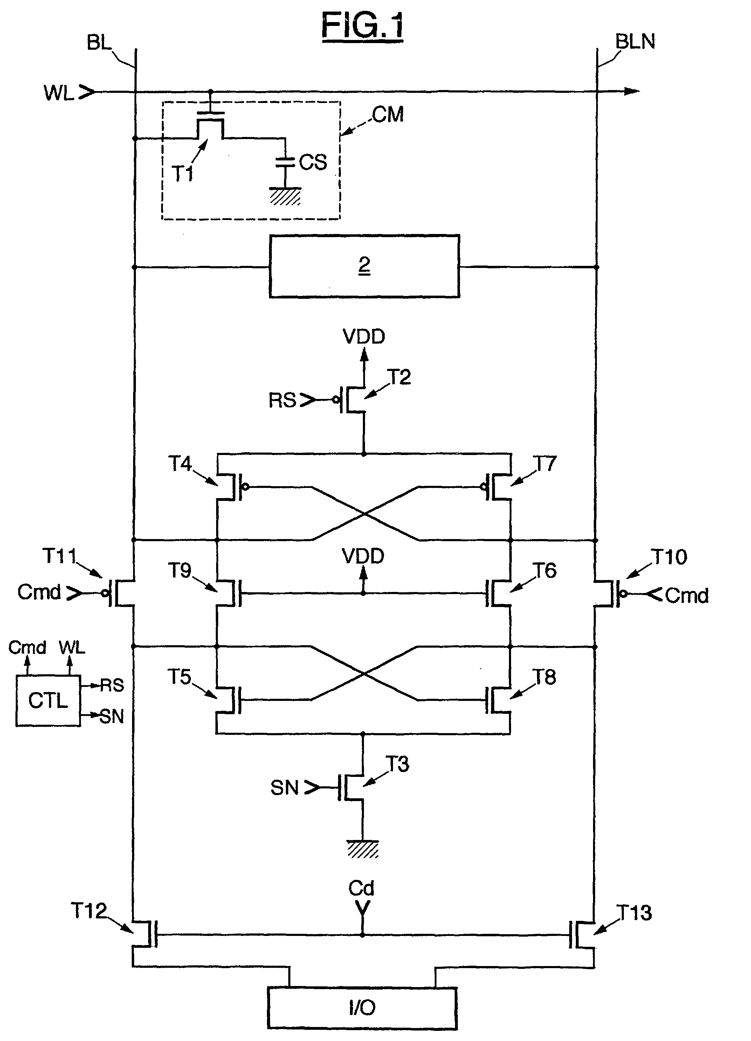

Sur la figure 1, on n'a représenté, à des fins de simplification, qu'une seule cellule-mémoire CM comportant une capacité de stockage CS et un seul transistor T1. Bien entendu, ces cellules-mémoire CM sont organisées en lignes et en colonnes.

Plus précisément, dans le cas illustré sur la figure 1, toutes les cellules-mémoire CM connectées à une même métallisation de colonne BL dite "Bit Line" sont sélectionnées par une ligne de mots WL ("word line"). La métallisation de la colonne adjacente BLN permet de connecter en quinconce d'autres lignes de cellules-mémoire CM pouvant être respectivement sélectionnées par le même signal de ligne de mots WL.

Classiquement, les deux colonnes BL et BLN sont connectées ou non à des moyens d'entrée/sortie I/O par deux transistors NMOS T12 et T13 commandés par un signal de commande Cd.

Dans l'exemple décrit ici, le dispositif 1 selon l'invention comporte des moyens d'amplification comportant deux inverseurs formés chacun de deux transistors à effet de champ à grilles isolées complémentaires, à savoir deux transistors PMOS T4 et T7 et deux transistors NMOS T5 et T8. Les sources des deux transistors PMOS T4 et T7 sont reliées à la tension de polarisation VDD de niveau élevé par l'intermédiaire d'un transistor PMOS T2 commandé par un signal de ré-écriture ("restore") RS.

De même, les sources des deux transistors NMOS T5 et T8 sont reliées à la masse par l'intermédiaire d'un transistor NMOS T3 commandé sur sa grille par un signal de lecture ("sense") SN.

Une structure de découplage est connectée entre les deux transistors PMOS T4 et T7 et les deux transistors NMOS T5 et T8. Cette structure de découplage est formée d'une première paire de transistors complémentaires formée d'un transistor NMOS T9 et d'un transistor PMOS T11, et d'une deuxième paire de transistors complémentaires formée d'un transistor NMOS T6 et d'un transistor PMOS T10. Les grilles des deux transistors de découplage NMOS sont reliées dans l'exemple décrit à la tension de polarisation VDD tandis que les grilles des deux transistors de découplage PMOS T10 et T11 sont commandées par un signal de commande Cmd.

Des moyens de contrôle CTL, de réalisation classique comportant des portes logiques notamment, délivrent les signaux WL, RS, SN et Cmd.

Par ailleurs, le dispositif comporte des moyens de précharge 2, de réalisation connue en soi, permettant de pécharger à un niveau de précharge choisi, par exemple VDD/2, les métallisations de colonnes BL et BLN.

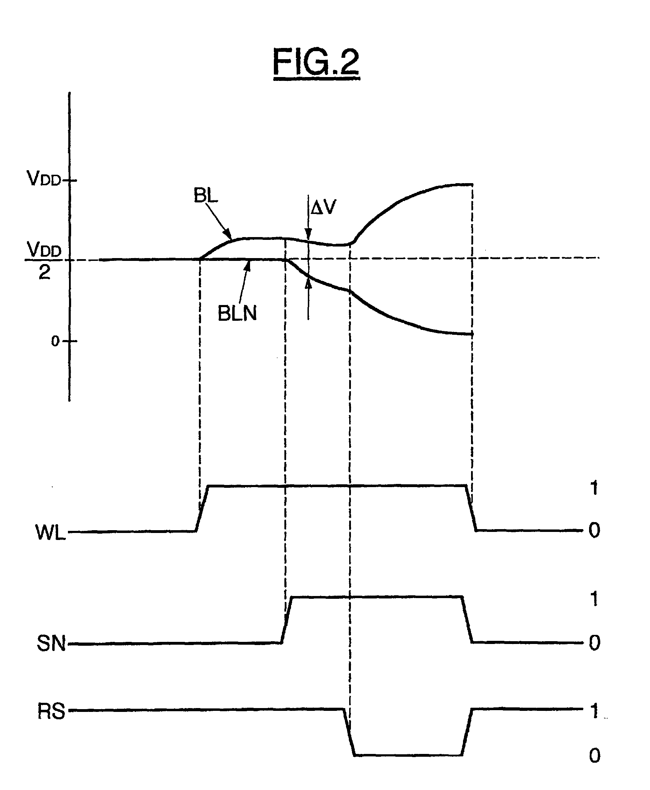

On va maintenant décrire, en se référant plus particulièrement à la figure 2, un mode de fonctionnement du dispositif selon l'invention correspondant à un cas où l'on souhaite lire et rafraîchir un "1" logique stocké dans la cellule-mémoire CM. On s'appuie également sur le mode de réalisation illustré sur la figure 1, dans lequel les transistors de découplage NMOS, dont les grilles sont polarisées à VDD, sont toujours passants.

Préalablement à la lecture/ré-écriture de la donnée, on effectue une phase de précharge dans laquelle on porte les potentiels des deux colonnes BL et BLN à VDD/2. Durant cette phase de précharge, le signal logique de commande Cmd est à "0" rendant les transistors de découplage PMOS T10 et T11 passants. Il convient de noter ici que le caractère passant de tous les transistors de découplage permet de n'utiliser qu'un seul circuit de précharge 2 (ce qui n'aurait pas été le cas si l'on avait utilisé comme structure de découplage uniquement deux des transistors NMOS T6 et T9), ce qui permet donc de minimiser la surface de la mémoire.

A l'issue de la phase de précharge, on désactive les moyens de précharge 2 et l'on met le signal Cmd à 1 ce qui bloque les transistors de découplage PMOS T10 et T11. L'homme du métier sait que la désactivation des moyens de précharge engendre une légère perturbation en tension par rapport à la tension nominale de précharge VDD/2, perturbation qui se retrouve sur la totalité des colonnes BL et BLN puisque les transistors de découplage NMOS T6 et T9 étaient passants lors de la désactivation des moyens de précharge. Ceci étant, à des fins de simplification, on n'a pas tenu compte de cette perturbation de tension sur les niveaux de tension indiqués sur la partie haute de la figure 2.

Au début du cycle de lecture/ré-écriture, on active le signal WL ce qui provoque la décharge de la capacité de stockage CS de la cellule-mémoire et la montée en tension de la colonne BL tandis que la colonne de référence BLN conserve sa valeur de tension de précharge (valeur de référence) VDD/2.

Lors de l'activation du signal de commande de lecture SN, il se produit une légère décroissance de la tension de la colonne BL et une décroissance beaucoup plus rapide de la tension de la colonne BLN car la tension de grille du transistor T8 est alors plus importante que la tension de grille du transistor T5. Le signe de la tension ΔV, qui peut être lue quasiment immédiatement après l'activation du signal SN, permet de déterminer la valeur logique de la donnée mémorisée. L'écart entre les tensions BL et BLN continue à s'amplifier permettant, lors de l'activation du signal RS (c'est-à-dire en fait lors du passage à zéro de ce signal RS), un rafraîchissement correct de la donnée mémorisée par une amplification de la tension BL jusqu'à la valeur VDD. Dans le même temps, la tension BLN continue de tendre vers zéro.

Le cycle de lecture/ré-écriture s'achève par la désactivation du signal WL suivie immédiatement par la désactivation du signal SN et du signal RS (remonté à " 1 " de ce signal).

Par ailleurs, lors d'une phase d'écriture dans la cellule-mémoire CM, on rend passant les transistors de découplage PMOS T10 et T11 (signal Cmd à "0") ce qui permet, lorsqu'on applique un niveau de tension élevé sur la ligne de bit BL pour l'écriture d'un "1" logique, d'éviter au passage de la structure de découplage une chute du niveau de tension égale la tension de seuil des transistors.

Dans un mode préféré de réalisation, il est particulièrement avantageux de disposer l'unique circuit de précharge 2 en bas de la colonne, c'est-à-dire à l'opposé de la cellule-mémoire par rapport aux moyens d'amplification et de rendre les transistors de découplage NMOS T6 et T9 commandables sur leur grille par un deuxième signal de commande (non représenté sur la figure 1 à des fins de simplification) au lieu de relier leur grille constamment à la tension de polarisation VDD. En effet, dans ce cas, juste avant de désactiver les moyens de précharge 2, on ouvre chaque interrupteur de découplage CMOS, c'est-à-dire que l'on bloque tous les transistors de découplage. Ainsi, lors de la désactivation du circuit de précharge, la perturbation de tension engendrée sera limitée à la partie basse des colonnes BL et BLN.

## Revendications

1. Dispositif de lecture/ré-écriture d'une cellule-mémoire d'une mémoire vive dynamique organisée en lignes et en colonnes, comprenant, pour chaque colonne, des moyens de précharge (2) et des moyens d'amplification comportant deux inverseurs (T4, T5, T7, T8) formés chacun de deux transistors complémentaires et commandés par deux signaux successifs de lecture (SN) et de ré-écriture (RS), les moyens d'amplification comprenant une structure de découplage formée de deux paires de transistors de découplage complémentaires connectés en parallèle (T6, T10, T9, T11), l'une des paires connectée entre les deux transistors de l'un des inverseurs, et l'autre des paires connectée entre les deux transisteurs de l'autre des inverseurs, **caractérisé par le fait que** la structure de découplage est apte à prendre sur commande au moins un premier état dans lequel tous les transistors de découplage sont passants, et un deuxième état dans lequel les deux transistors de découplage (T9,T6) ayant un canal de même type de conductivité sont passants tandis que les deux autres transistors de découplage (T10,T11) sont bloqués.

2. Dispositif selon la revendication 1, **caractérisé par le fait que** les moyens de précharge ne comportent qu'un seul circuit de précharge (2) connecté en parallèle sur les moyens d'amplification du côté de la cellule-mémoire (CM) ou à l'opposé de la cellule-mémoire (CN) par rapport aux moyens d'amplification.

3. Dispositif selon l'une des revendications précédentes, **caractérisé par le fait que** les grilles de deux transistors de découplage (T6, T9) ayant un même type de canal sont connectées à une tension de polarisation prédéterminée (VDD) de façon à rendre ces deux transistors de découplage toujours passants, les grilles des deux autres transistors de découplage T10, T11) étant commandés par un même signal de commande (Cmd) à deux états logiques de façon à rendre ces deux autres transistors de découplage passants ou bloqués.

4. Dispositif selon la revendication 2, **caractérisé par le fait que** le circuit de précharge (2) est connecté en parallèle sur les moyens d'amplification à l'opposé de la cellule-mémoire (CM) par rapport aux moyens d'amplification, et **par le fait que** la structure de découplage est apte à prendre un troisième état dans lequel tous les transistors de découplage sont bloqués.

5. Dispositif selon la revendication 4, **caractérisé par le fait que** les grilles de deux transistors de découplage ayant un même type de canal (T6, T9) sont commandées par un même premier signal de commande à deux états logiques de façon à rendre ces deux transistors de découplage passants ou bloqués, et les grilles des deux autres transistors de découplage (T10, T11) sont commandées par un même deuxième signal de commande à deux états logiques de façon à rendre ces deux autres transistors de découplage passants ou bloqués.

6. Procédé de commande d'un dispositif de lecture/ré-écriture selon la revendication 1 procédé dans lequel on place la structure de découplage dans son premier état au cours d'un cycle d'écriture dans la cellule-mémoire et on place la structure de découplage dans son deuxième état au cours d'un cycle de lecture ré-écriture suivant une phase de précharge.

7. Procédé selon la revendication 6, pour un dispositif dont les moyens de précharge ne comportent qu'un seul circuit de précharge (2) connecté en parallèle sur les moyens d'amplification du côté de la cellule-mémoire ou à l'opposé de la cellule-mémoire par rapport aux moyens d'amplification, **caractérisé par le fait qu'**on place la structure de découplage dans son premier état au cours d'une partie au moins de la phase de précharge.

8. Procédé selon la revendication 7, **caractérisé par le fait qu'**on place la structure de découplage dans son premier état au cours de la totalité de la phase de précharge.

9. Procédé selon la revendication 7, pour un dispositif dont l'unique circuit de précharge (2) est connecté en parallèle sur les moyens d'amplification à l'opposé de la cellule-mémoire par rapport aux moyens d'amplification, et dont la structure de découplage est apte à prendre un troisième état dans lequel tous les transistors de découplage sont bloqués, **caractérisé par le fait que**, durant la phase de précharge, on place d'abord la structure de découplage dans son premier état, puis juste avant de désactiver les moyens de précharge (2), on place la structure de découplage dans son troisième état.

## Patentansprüche

1. Vorrichtung zum Lesen und Überschreiben einer Speicherzelle eines in Zeilen und Spalten organisierten dynamischen Speichers, der für jede Spalte eine Voraufladeeinrichtung (2) und eine Verstärkungseinrichtung aufweist, die zwei Inverter (T4, T5, T7, T8) aufweist, die jeweils mit zwei komplementären und von zwei aufeinanderfolgenden Lese- (SN) und Überschreib- (RS) Signalen gesteuerten Transistoren gebildet sind, wobei die Verstärkungseinrichtung eine Entkopplungsstruktur aufweist, die mit zwei Paaren von parallel geschalteten komplementären Entkopplungstransistoren (T6, T10, T9, T11) gebildet ist, wobei eines der Paare zwischen den zwei Transistoren des einen Inverters angeschlossen ist und das andere Paar zwischen den zwei Transistoren des anderen Inverters angeschlossen ist, **dadurch gekennzeichnet, daß** die Entkopplungsstruktur auf einen Befehl hin mindestens einen ersten Zustand, in welchem alle Entkopplungstransistoren leitend sind, und einen zweiten Zustand einnehmen kann, in welchem die zwei Entkopplungstransistoren (T9, T6), die einen Kanal des gleichen Leitungstyps haben, leitend sind, während die zwei anderen Entkopplungstransistoren (T10, T11) gesperrt sind.

2. Vorrichtung nach Anspruch 1, **dadurch gekennzeichnet, daß** die Voraufladeeinrichtung nur eine einzige Voraufladeschaltung (2) aufweist, die parallel zur Verstärkungseinrichtung und, bezogen auf die Verstärkungseinrichtung, auf der gleichen Seite wie die Speicherzelle (CM) oder auf der zur Speicherzelle entgegengesetzten Seite angeordnet ist.

3. Vorrichtung nach einem der vorstehenden Ansprüche, **dadurch gekennzeichnet, daß** die Gatter zweier Entkopplungstransistoren (T6, T9), die einen gleichen Kanaltyp haben, mit einer vorgegebenen Vorspannung (VDD) verbunden sind, so daß diese zwei Entkopplungstransistoren immer leitend sind, wobei die Gatter der zwei anderen Entkopplungstransistoren (T10, T11) von einem gleichen Steuersignal (Cmd) in zwei logische Zustände gesteuert werden, so daß diese zwei anderen Entkopplungstransistoren leitend oder sperrend gemacht sind.

4. Vorrichtung nach Anspruch 2, **dadurch gekennzeichnet, daß** die Voraufladeschaltung (2) parallel zur Verstärkungseinrichtung und, bezogen auf die Verstärkungseinrichtung, auf der zur Speicherzelle entgegengesetzten Seite angeordnet ist, und dadurch, daß die Entkopplungsstruktur einen dritten Zustand einnehmen kann, in welchem alle Entkopplungstransistoren gesperrt sind.

5. Vorrichtung nach Anspruch 4, **dadurch gekennzeichnet, daß** die Gatter zweier Entkopplungstransistoren (T6, T9), die einen gleichen Kanaltyp haben, von einem gleichen ersten Steuersignal in zwei logische Zustände gesteuert werden, so daß diese zwei Entkopplungstransistoren leitend oder sperrend gemacht sind, und die Gatter der zwei anderen Entkopplungstransistoren (T10, T11) von einem gleichen zweiten Steuersignal in zwei logische Zustände gesteuert werden, so daß diese zwei anderen Entkopplungstransistoren leitend oder sperrend gemacht sind.

6. Verfahren zur Steuerung einer Lese/Überschreib-Vorrichtung nach Anspruch 1, in welchem im Verlaufe eines Zyklus des Schreibens in die Speicherzelle die Entkopplungsstruktur in ihren ersten Zustand gebracht wird und nach einer Voraufladephase im Verlaufe eines Zyklus des Lesens/Überschreibens die Entkopplungsstruktur in ihren zweiten Zustand gebracht wird.

7. Verfahren nach Anspruch 6 für eine Vorrichtung, deren Voraufladeeinrichtung nur eine einzige Voraufladeschaltung (2) aufweist, die parallel zur Verstärkungseinrichtung und, bezogen auf die Verstärkungseinrichtung, auf der gleichen Seite wie die Speicherzelle oder auf der zur Speicherzelle entgegengesetzten Seite angeordnet ist, **dadurch gekennzeichnet, daß** im Verlaufe mindestens eines Teils der Voraufladephase die Entkopplungsstruktur in ihren ersten Zustand gebracht wird.

8. Verfahren nach Anspruch 7, **dadurch gekennzeichnet, daß** während der gesamten Voraufladephase die Entkopplungsstruktur in ihren ersten Zustand gebracht ist.

9. Verfahren nach Anspruch 7 für eine Vorrichtung, deren einzige Voraufladeschaltung (2) parallel zur Verstärkungseinrichtung und, bezogen auf die Verstärkungseinrichtung, auf der zur Speicherzelle entgegengesetzten Seite angeschlossen ist, und deren Entkopplungsstruktur einen dritten Zustand einnehmen kann, in welchem alle Entkopplungstransistoren gesperrt sind, **dadurch gekennzeichnet, daß** während der Voraufladephase die Entkopplungsstruktur in ihren ersten Zustand gebracht ist, und dann unmittelbar vor Deaktivieren der Voraufladeeinrichtung (2) die Entkopplungsstruktur in ihren dritten Zustand gebracht wird.

## Claims

1. Device for reading/rewriting a memory cell of a dynamic random access memory laid out in rows and columns, comprising, for each column, precharge means (2) and amplification means comprising two inverters (T4, T5, T7, T8) each formed'by two complementary transistors and controlled by two successive signals, read (SN) and rewrite (RS), the amplification means comprising a decoupling structure formed by two pairs of complementary decoupling transistors connected in parallel (T6, T10, T9, T11), one of the pairs connected between the two transistors of one of the inverters and the other of the pairs connected between the two transistors of the other of the inverters, **characterized in that** the decoupling structure is able on command to take at least a first state in which all the decoupling transistors are on, and a second state in which the two decoupling transistors (T9, T6) having a channel with the same type of conductivity are on, while the other two decoupling transistors (T10, T11) are off.

2. Device according to Claim 1, **characterized in that** the precharge means comprise just a single precharge circuit (2) connected in parallel with the amplification means on the same side as the memory cell (CM) or on the opposite side from the memory cell (CN) with respect to the amplification means.

3. Device according to one of the preceding claims, **characterized in that** the gates of two decoupling transistors (T6, T9) having the same channel type are connected to a predetermined bias voltage (VDD) so as to render these two decoupling transistors permanently on, the gates of the other two decoupling transistors (T10, T11) being controlled by the same control signal (Cmd) with two logic states so as to render these other two decoupling transistors on or off.

4. Device according to Claim 2, **characterized in that** the precharge circuit (2) is connected in parallel with the amplification means on the opposite side from the memory cell (CM) with respect to the amplification means, and **in that** the decoupling structure is able to take a third state in which all the decoupling transistors are off.

5. Device according to Claim 4, **characterized in that** the gates of two decoupling transistors having the same channel type (T6, T9) are controlled by a first control signal with two logic states in such a way as to render these two decoupling transistors on or off, and the gates of the other two decoupling transistors (T10, T11) are controlled by the same second control signal with two logic states in such a way as to render these other two decoupling transistors on or off.

6. Process for controlling a reading/rewriting device according to claim 1, in which process the decoupling structure is placed in its first state in the course of a cycle of writing to the memory cell and the decoupling structure is placed in its second state in the course of a read/rewrite cycle following a precharge phase.

7. Process according to Claim 6, for a device whose precharge means comprise just a single precharge circuit (2) connected in parallel with the amplification means on the same side as the memory cell or on the opposite side from the memory cell with respect to the amplification means **characterized in that** the decoupling structure is placed in its first state in the course of a part at least of the precharge phase.

8. Process according to Claim 7, **characterized in that** the decoupling structure is placed in its first state in the course of the whole of the precharge phase.

9. Process according to Claim 7, for a device whose single precharge circuit (2) is connected in parallel with the amplification means on the opposite side from the memory cell with respect to the amplification means, and whose decoupling structure is able to take a third state in which all the decoupling transistors are off, **characterized in that**, during the precharge phase, the decoupling structure is firstly placed in its first state, and then just before deactivating the precharge means (2), the decoupling structure is placed in its third state.
